# FASCICULE DE BREVET EUROPEEN

(11) **EP 4 214 798 B1**
(45) Date de publication et mention de la délivrance du brevet: **24.09.2025**
(21) Numéro de dépôt: 21773131.4
(22) Date de dépôt: 03.08.2021
(51) Int. Cl.: H01Q 1/02, H01Q 1/32, H01Q 1/42, H05K 7/20

(54) **PROTECTION THERMIQUE PASSIVE D'UN BOÎTIER DE CONNECTIVITÉ**
PASSIVER WÄRMESCHUTZ EINES KONNEKTIVITÄTSGEHÄUSES
PASSIVE THERMAL PROTECTION OF A CONNECTIVITY HOUSING

(30) Priorité: 21.09.2020 FR 2009536
(43) Date de publication de la demande: 26.07.2023
(73) Titulaire: Stellantis Auto SAS, 78300 Poissy (FR)
(72) Inventeur: EL ARABI, Yasser, Temara, 12010 (MA)
(74) Mandataire: ESIP
(86) Numéro de dépôt international: PCT/FR2021/051438
(87) Numéro de publication internationale: WO 2022/058668

(56) Documents cités:
- EP-A1- 2 998 939
- FR-A1- 3 030 125

## Description

La présente invention appartient au domaine des composants électroniques en charge de la connectivité d'un véhicule. En particulier, elle concerne le refroidissement passif d'un boitier de connectivité configuré pour être disposé sur une surface extérieure du véhicule.

On entend par « véhicule » tout type de véhicule tel qu'un véhicule automobile, un cyclomoteur, un avion, un train, une motocyclette, un robot de stockage dans un entrepôt, etc.

On entend par « configuré pour être disposé sous une surface extérieure du véhicule » que le boitier de connectivité est assemblé sous la carrosserie du véhicule. En particulier, le boitier de connectivité est collé ou vissé directement sous la carrosserie. Il peut également être inséré dans un logement (cavité de la carrosserie dédiée à la réception du boitier) puis collé ou vissé. Dans un mode de réalisation, le boitier est collé ou vissé sur la carrosserie. Les boitiers de connectivité de dernière génération sont généralement liés directement à une surface extérieure du véhicule. Un tel agencement pose des problèmes de surchauffe des composants électroniques compris dans le boitier. Ces composants électroniques génèrent eux-mêmes une importante énergie thermique (chaleur) et, de par leur disposition sur la carrosserie, subissent l'énergie thermique apportée par l'environnement extérieur. Typiquement, un boitier de connectivité générant lui-même une importante énergie thermique installé sous une carrosserie peinte d'une couleur sombre (couleur de la carrosserie), recevant directement les rayons du soleil peut voir son fonctionnement dégradé.

Il existe donc un besoin pour limiter les effets de surchauffe des boitiers de connectivité.

EP2998939A1 divulgue un boîtier de connectivité comprenant une couche comprenant un matériau à changement de phase.

La présente invention vient améliorer la situation.

A cet effet un premier aspect de l'invention concerne un boitier de connectivité selon la revendication 1.

Le matériau à changement de phase de la première couche absorbante présente une grande conductivité thermique aux basses températures et une basse conductivité thermique à grande température. Ainsi, l'énergie thermique dégagée par la partie centrale est absorbée.

Au contraire, la deuxième couche isolante présente une basse conductivité thermique aux basses températures et une haute conductivité thermique à grande température, elle évite une transmission de l'énergie thermique de l'environnement extérieur vers la partie centrale. Le couplage des deux couches (à comportements de la conductivité thermique opposés) fonctionne donc sur le principe de la rectification thermique : laisser l'énergie thermique passer dans un sens et non pas dans l'autre.

Une protection thermique passive efficace est ainsi mise en place.

Selon l'invention, la première couche absorbante recouvre au moins partiellement la surface extérieure de la partie centrale et la deuxième couche isolante recouvre totalement la surface extérieure de la première couche absorbante. Dans un mode de réalisation, le recouvrement est configuré pour éviter au maximum le risque de la création des ponts thermiques.

On entend par « surface extérieure de la première couche absorbante » la surface de la première couche absorbante qui serait en contact avec l'extérieur (air ambiant) en l'absence de la deuxième couche isolante.

Selon l'invention, l'antenne est disposée sur une portion de la surface extérieure de la partie centrale, et dans lequel la première couche absorbante recouvre totalement la surface extérieure de la partie centrale à l'exception de la portion.

Ces agencements présentent les meilleures protections thermiques.

Dans un mode de réalisation, la partie centrale est l'un au moins un des éléments parmi :
- un ensemble de composants électroniques configurés pour traiter des signaux émis et reçus par l'antenne ;
- la totalité des composants électroniques bu boitier à l'exception de l'antenne.

Dans un mode de réalisation, la deuxième couche isolante comporte un matériau isolant présentant l'une au moins des caractéristiques suivantes :
- le matériau isolant comporte de la mousse polyuréthane flexible ;
- le matériau isolant comporte une densité supérieure supérieure à 50 kilogrammes par mètre cube ;
- le matériau isolant est configuré pour présenter une conductivité thermique comprise entre 0,03 watts par mètre-kelvin et 0,05 watts par mètre-kelvin.

Un deuxième aspect de l'invention concerne un véhicule comportant le boitier de connectivité selon le premier aspect de l'invention.

Un troisième aspect de l'invention concerne un procédé d'émission d'une donnée par un boitier de connectivité selon la revendication 5.

Un quatrième aspect de l'invention concerne un procédé de réception d'un signal par un boitier selon la revendication 6.

D'autres caractéristiques et avantages de l'invention apparaîtront à l'examen de la description détaillée ci-après, et des dessins annexés sur lesquels :
[Fig 1] est un schéma illustrant le boitier de connectivité en perspective selon un mode de réalisation de l'invention ;
[Fig 2] est un schéma illustrant le boitier de connectivité en vue de côté selon un mode de réalisation de l'invention ;
[Fig 3] est un schéma illustrant le boitier de connectivité en vue de face selon un mode de réalisation de l'invention.

L'invention est décrite ci-après dans son application, non limitative, au cas d'un boitier de connectivité implanté sur le toit d'un véhicule automobile. D'autres applications, telles qu'un boitier de connectivité implanté sur le guidon d'un vélo électrique ou disposé sur un phare d'un cyclomoteur sont également envisageables.

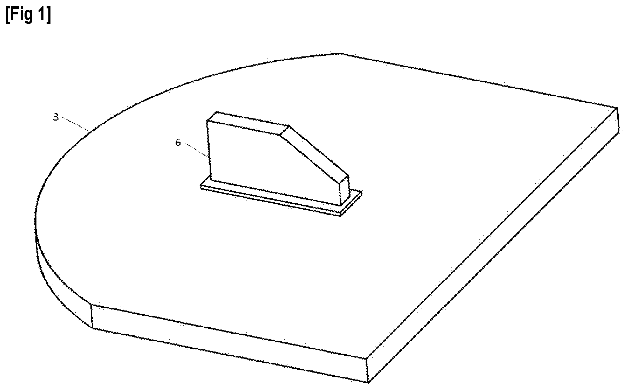

La **figure 1** est un schéma illustrant le boitier de connectivité en perspective selon un mode de réalisation de l'invention.

Le boitier de connectivité 3 présente une forme plate sur laquelle est disposé une antenne 6.

Le boitier de connectivité est collé ou vissé sur la carrosserie du véhicule automobile. Il peut également être inséré dans un logement (cavité de la carrosserie dédiée à la réception du boitier) puis collé ou vissé.

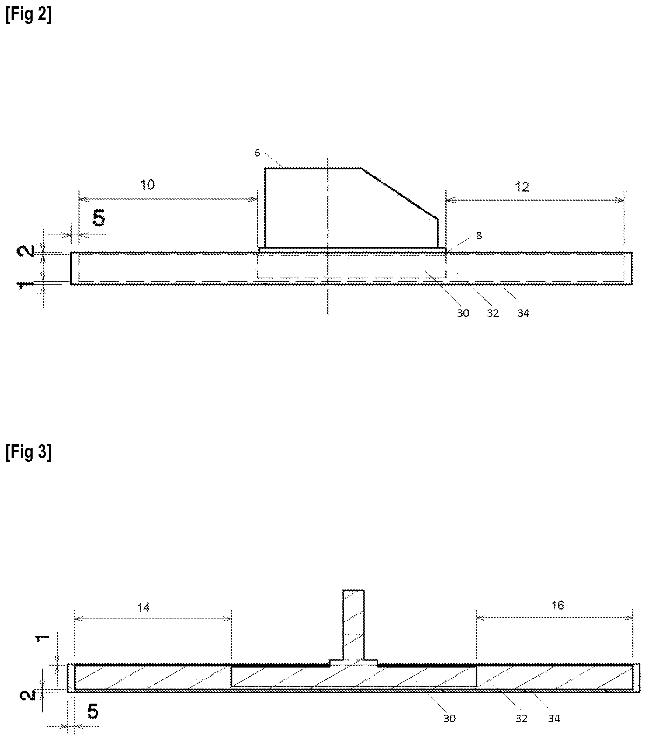

La **figure 2** illustre le boitier de connectivité en vue de côté selon un mode de réalisation de l'invention et la **figure 3** en vue de face selon un mode de réalisation de l'invention.

Le boitier de connectivité 3 comprend l'antenne 6 et une partie centrale 30 située sous l'antenne 6. La partie centrale comporte des composants électroniques. Dans un mode de réalisation, la partie centrale comporte tous les composants électroniques du boitier de connectivité à l'exception de l'antenne. Dans un autre mode de réalisation, la partie centrale comporte un ensemble de composants électroniques configurés pour traiter des signaux émis et reçus par l'antenne, par exemple ceux comportant les ressources de calcul le plus émettrice d'énergie thermique du boitier de connectivité (processeur, modem, etc.), les autres composants étant par exemple intégrés dans l'antenne.

La partie centrale se présente sous la forme d'un boitier en plastique dans lequel sont situés les composants électroniques. Dans un autre mode de réalisation, la partie centrale consiste directement en les composants électroniques, sans boitier, reliés entre eux par un ou plusieurs circuits imprimés.

Le boitier de connectivité comporte en outre :
- une première couche absorbante 32 comportant un matériau à changement de phase, le matériau à changement de phase étant configuré pour absorber une énergie thermique émise par la partie centrale 30 ;
- une deuxième couche isolante 34 configuré pour isoler thermiquement la première couche absorbante et la partie centrale d'une énergie thermique extérieure.

Le matériau à changement de phase change de phase autour de 70 degrés Celsius, préférentiellement entre 60 et 80 degrés Celsius, très préférentiellement à 70 degrés Celsius. Le matériau à changement de phase change ainsi de phase à 70°Celsius, pendant ce changement de phase, il absorbe de la chaleur produite par la partie centrale (en tant que chaleur sensible, puis chaleur latente de fusion). Un exemple de matériau à changement de phase est le produit ClimSel MARQUE DEPOSEE C70.

La deuxième couche isolante comporte un matériau isolant présentant l'une au moins des caractéristiques suivantes :
- le matériau isolant comporte de la mousse polyuréthane flexible ;
- le matériau isolant comporte une densité supérieure supérieure à 50 kilogrammes par mètre cube ;
- le matériau isolant est configuré pour présenter une conductivité thermique comprise entre 0,03 watts par mètre-kelvin et 0,05 watts par mètre-kelvin.

Selon l'invention, la première couche absorbante 32 recouvre au moins partiellement la surface extérieure de la partie centrale 30 et la deuxième couche isolante 34 recouvre totalement la surface extérieure de la première couche absorbante.

Dans un mode de réalisation ici représenté figures 2 et 3, la première couche absorbante 32 recouvre totalement la surface extérieure de la partie centrale 30. En particulier, au niveau d'une zone 8 située entre la partie centrale et l'antenne, les deux couches sont présentes et le lien électronique entre l'antenne et la partie centrale est assurée par au moins une liaison filaire noyée dans la première couche absorbante au niveau de la zone 8.

Dans un mode de réalisation, la deuxième couche isolante 34 présente :
- une épaisseur 2 sur la face supérieure d'au moins 1 mm;
- une épaisseur 1 sur la face inférieure d'au moins 2 mm ;
- une épaisseur 5 sur la face latérale comprise entre 4 mm et 6 mm, préférentiellement 5 mm.

Dans un mode de réalisation, la première couche absorbante 32 présente :
- Une épaisseur sur la face supérieure d'au moins 1 mm ;
- Une épaisseur sur la face inférieure d'au moins 2 mm ;
- Une épaisseur 10,12,14,16 sur la face latérale d'au moins 115 mm ;

Selon l'invention, l'antenne 6 est disposée (par exemple collée ou vissée) sur une portion de la surface extérieure de la partie centrale, et dans lequel la première couche absorbante recouvre totalement la surface extérieure de la partie centrale à l'exception de la portion.

L'invention concerne en outre un procédé d'émission (non représenté) d'une donnée par un boitier de connectivité configuré pour être disposé sur une partie extérieure d'un véhicule terrestre à moteur et comprenant au moins une antenne et une partie centrale, le boitier de connectivité comportant :
- une première couche absorbante comportant un matériau à changement de phase, le matériau à changement de phase étant configuré pour absorber une énergie thermique émise par la partie centrale ;
- une deuxième couche isolante configuré pour isoler thermiquement la première couche absorbante et la partie centrale d'une énergie thermique extérieure ;
le procédé comportant les étapes de :
- traitement de la donnée par un composant électronique compris dans la partie centrale. Les étapes de traitement sont de types divers et correspondent à ceux effectué par un boitier de connectivité, tel que les opérations de mise en forme de la donnée pour une transmission radiofréquence (modulation, multiplexage, filtrage, etc.) ou encore de gestion des ressources de transmission (stockage temporaire si réseau indisponible, etc.) ;
- émission de la donnée traitée par l'antenne.

L'invention concerne en outre un procédé réception d'un signal par un boitier de connectivité configuré pour être disposé sur une partie extérieure d'un véhicule terrestre à moteur et comprenant au moins une antenne et une partie centrale, le boitier de connectivité comportant :
- une première couche absorbante comportant un matériau à changement de phase, le matériau à changement de phase étant configuré pour absorber une énergie thermique émise par la partie centrale ;
- une deuxième couche isolante configuré pour isoler thermiquement la première couche absorbante et la partie centrale d'une énergie thermique extérieure ;
le procédé comportant les étapes de :
- réception du signal par l'antenne ;
- traitement du signal par un composant électronique compris dans la partie centrale. Les étapes de traitement sont de types divers et correspondent à ceux effectué par un boitier de connectivité, tel que les opérations de mise en forme de la donnée pour un traitement numérique par des composants du véhicule (démodulation, démultiplexage, filtrage, etc.).

La présente invention ne se limite pas aux formes de réalisation décrites ci-avant à titre d'exemples ; elle s'étend à d'autres variantes.

Ainsi, il a été décrit un mode de réalisation dans lequel l'invention était mise en œuvre pour un boitier de connectivité présentant une antenne de type aileron de requin. L'invention peut toutefois être mis en œuvre pour tout type d'antenne tel qu'une antenne patch ou filaire.

## Revendications

1. Boitier de connectivité (3) configuré pour être disposé sous une partie extérieure d'un véhicule terrestre à moteur et comprenant au moins une antenne (6) et une partie centrale (30), le boitier de connectivité comportant :
- une première couche absorbante (32) comportant un matériau à changement de phase, le matériau à changement de phase étant configuré pour absorber une énergie thermique émise par la partie centrale ;
- une deuxième couche isolante (34) configuré pour isoler thermiquement la première couche absorbante et la partie centrale d'une énergie thermique extérieure,
dans lequel la première couche absorbante recouvre au moins partiellement la surface extérieure de la partie centrale et la deuxième couche isolante recouvre totalement la surface extérieure de la première couche absorbante, et
**caractérisé en ce que**
l'antenne est disposée sur une portion de la surface extérieure de la partie centrale, et dans lequel la première couche absorbante recouvre totalement la surface extérieure de la partie centrale à l'exception de la portion.

2. Boitier selon l'une des revendications précédentes, dans lequel la partie centrale est l'un au moins un des éléments parmi :
- un ensemble de composants électroniques configurés pour traiter des signaux émis et reçus par l'antenne ;
- la totalité des composants électroniques bu boitier à l'exception de l'antenne.

3. Boitier selon l'une des revendications précédentes, dans lequel la deuxième couche isolante comporte un matériau isolant présentant l'une au moins des caractéristiques suivantes :
- le matériau isolant comporte de la mousse polyuréthane flexible ;
- le matériau isolant comporte une densité supérieure d'au moins 50 kilogrammes par mètre cube ;
- le matériau isolant est configuré pour présenter une conductivité thermique comprise entre 0,03 watts par mètre-kelvin et 0,04 watts par mètre-kelvin.

4. Véhicule comportant le boitier de connectivité (3) selon l'une des revendications précédentes.

5. Procédé d'émission d'une donnée par un boitier de connectivité configuré pour être disposé sous une partie extérieure d'un véhicule terrestre à moteur et comprenant au moins une antenne et une partie centrale, le boitier de connectivité comportant :
- une première couche absorbante comportant un matériau à changement de phase, le matériau à changement de phase étant configuré pour absorber une énergie thermique émise par la partie centrale ;
- une deuxième couche isolante configurée pour isoler thermiquement la première couche absorbante et la partie centrale d'une énergie thermique extérieure,
dans lequel la première couche absorbante recouvre au moins partiellement la surface extérieure de la partie centrale et la deuxième couche isolante recouvre totalement la surface extérieure de la première couche absorbante,
dans lequel l'antenne est disposée sur une portion de la surface extérieure de la partie centrale, et dans lequel la première couche absorbante recouvre totalement la surface extérieure de la partie centrale à l'exception de la portion
le procédé comportant les étapes de :
- traitement de la donnée par un composant électronique compris dans la partie centrale ;
- émission de la donnée traitée par l'antenne.

6. Procédé de réception d'un signal par un boitier de connectivité configuré pour être disposé sous une partie extérieure d'un véhicule terrestre à moteur et comprenant au moins une antenne et une partie centrale, le boitier de connectivité comportant :
- une première couche absorbante comportant un matériau à changement de phase, le matériau à changement de phase étant configuré pour absorber une énergie thermique émise par la partie centrale ;
- une deuxième couche isolante configuré pour isoler thermiquement la première couche absorbante et la partie centrale d'une énergie thermique extérieure,
dans lequel la première couche absorbante recouvre au moins partiellement la surface extérieure de la partie centrale et la deuxième couche isolante recouvre totalement la surface extérieure de la première couche absorbante,
dans lequel l'antenne est disposée sur une portion de la surface extérieure de la partie centrale, et dans lequel la première couche absorbante recouvre totalement la surface extérieure de la partie centrale à l'exception de la portion,
le procédé comportant les étapes de :
- réception du signal par l'antenne ;
- traitement du signal par un composant électronique compris dans la partie centrale.

## Patentansprüche

1. Anschlussgehäuse (3), das zur Anordnung unter einem Außenteil eines Kraftfahrzeugs ausgebildet ist und mindestens eine Antenne (6) und einen Mittelteil (30) umfasst, wobei das Anschlussgehäuse Folgendes umfasst:
- eine erste absorbierende Schicht (32), die ein Phasenänderungsmaterial umfasst, wobei das Phasenänderungsmaterial so konfiguriert ist, dass es vom zentralen Teil emittierte Wärmeenergie absorbiert;
- eine zweite Isolierschicht (34), die so gestaltet ist, dass sie die erste absorbierende Schicht und den zentralen Teil von äußerer Wärmeenergie thermisch isoliert,
wobei die erste absorbierende Schicht zumindest teilweise die Außenfläche des zentralen Teils bedeckt und die zweite isolierende Schicht die Außenfläche der ersten absorbierenden Schicht vollständig bedeckt und
die Erfindung ist **dadurch gekennzeichnet, dass** die Antenne auf einem Teil der Außenfläche des Mittelteils angeordnet ist, wobei die erste absorbierende Schicht die Außenfläche des Mittelteils mit Ausnahme des Teils vollständig bedeckt.

2. Gehäuse nach einem der vorhergehenden Ansprüche, bei dem der Mittelteil mindestens eines der folgenden Elemente ist:
- eine Reihe elektronischer Bauteile, die so konfiguriert sind, dass sie von der Antenne ausgesendete und empfangene Signale verarbeiten;
- alle elektronischen Komponenten des Gehäuses mit Ausnahme der Antenne.

3. Gehäuse nach einem der vorhergehenden Ansprüche, bei dem die zweite Isolierschicht ein Isoliermaterial mit mindestens einer der folgenden Eigenschaften aufweist:
- das Isoliermaterial besteht aus flexiblem Polyurethanschaum;
- das Isoliermaterial eine Dichte von mindestens 50 kg pro Kubikmeter aufweist;
- das Isoliermaterial ist so konfiguriert, dass es eine Wärmeleitfähigkeit von 0,03 Watt pro Meter Kelvin bis 0,04 Watt pro Meter Kelvin aufweist.

4. Fahrzeug mit dem Anschlussgehäuse (3) nach einem der vorhergehenden Ansprüche.

5. Verfahren zum Senden von Daten von einem Konnektivitätsgehäuse, das so konfiguriert ist, dass es unter einem äußeren Teil eines Kraftfahrzeugs angeordnet ist und mindestens eine Antenne und einen mittleren Teil umfasst, wobei das Konnektivitätsgehäuse Folgendes umfasst:
- eine erste absorbierende Schicht, die ein Phasenänderungsmaterial umfasst, wobei das Phasenänderungsmaterial so konfiguriert ist, dass es vom zentralen Teil emittierte Wärmeenergie absorbiert;
- eine zweite Isolierschicht, die so gestaltet ist, dass sie die erste absorbierende Schicht und den zentralen Teil von äußerer Wärmeenergie wärmeisoliert,
wobei die erste absorbierende Schicht zumindest teilweise die Außenfläche des zentralen Teils bedeckt und die zweite isolierende Schicht die Außenfläche der ersten absorbierenden Schicht vollständig bedeckt,
wobei die Antenne auf einem Teil der Außenfläche des Mittelteils angeordnet ist und wobei die erste absorbierende Schicht die Außenfläche des Mittelteils mit Ausnahme des Teils vollständig bedeckt
das Verfahren umfasst folgende Schritte:
- Datenverarbeitung durch ein elektronisches Bauteil im zentralen Teil;
- Übertragung der von der Antenne verarbeiteten Daten.

6. Verfahren zum Empfangen eines Signals von einem Konnektivitätsgehäuse, das zur Anordnung unter einem äußeren Teil eines Kraftfahrzeugs konfiguriert ist und mindestens eine Antenne und einen mittleren Teil umfasst, wobei das Konnektivitätsgehäuse Folgendes umfasst:
- eine erste absorbierende Schicht, die ein Phasenänderungsmaterial umfasst, wobei das Phasenänderungsmaterial so konfiguriert ist, dass es vom zentralen Teil emittierte Wärmeenergie absorbiert;
- eine zweite Isolierschicht, die so konfiguriert ist, dass sie die erste absorbierende Schicht und den zentralen Teil von äußerer Wärmeenergie thermisch isoliert,
wobei die erste absorbierende Schicht zumindest teilweise die Außenfläche des zentralen Teils bedeckt und die zweite isolierende Schicht die Außenfläche der ersten absorbierenden Schicht vollständig bedeckt,
bei dem die Antenne auf einem Teil der Außenfläche des Mittelteils angeordnet ist und die erste absorbierende Schicht die Außenfläche des Mittelteils mit Ausnahme des Teils vollständig bedeckt,
das Verfahren umfasst folgende Schritte:
- Empfang des Signals über die Antenne;
- Signalverarbeitung durch ein elektronisches Bauteil, das im mittleren Teil enthalten ist.

## Claims

1. Connectivity box (3) configured to be arranged under an outer part of an engine land vehicle and comprising at least one antenna (6) and a centre part (30), the connectivity box comprising:
- a first absorbing layer (32) comprising a phase change material, the phase change material being configured to absorb thermal energy emitted from the core;
- a second insulating layer (34) configured to thermally insulate a first absorbing layer and a core portion from outside thermal energy,
wherein the first absorbing layer at least partially covers the outer surface of the central portion and the second insulating layer totally covers the outer surface of the first absorbing layer, and
wherein the antenna is disposed on a portion of the outer surface of the core portion, and
wherein the first absorbing layer completely covers the outer surface of the core portion except for the portion.

2. Connectivity box according to the previous claims, in which the central part is at least one of the items:
- a set of electronic components configured to process signals transmitted and received by the antenna;
- all electronic components in the housing except the antenna.

3. Connectivity box according to any of the previous claims, wherein the second insulating layer comprises an insulating material having at least one of the following characteristics:
- the insulating material comprises flexible polyurethane foam;
- the insulating material has a higher density of at least 50 kilogrammes per cubic metre;
- the insulating material is configured to have a thermal conductivity between 0.03 watts per kelvin metre and 0.04 watts per kelvin metre.

4. Vehicle comprising the connectivity box (3) according to one of the previous claims.

5. Method for transmitting data by a connectivity box configured to be arranged under an outer part of an engine land vehicle and comprising at least one antenna and a central part, the connectivity box comprising:
- a first absorbing layer comprising a phase-change material, the phase-change material being configured to absorb thermal energy emitted by the core;
- a second insulating layer configured to thermally insulate the first absorbing layer and the core part from outside thermal energy,
in which the first absorbing layer at least partially covers the outer surface of the central part and the second insulating layer totally covers the outer surface of the first absorbing layer,
in which the antenna is arranged on a portion of the outer surface of the core part, and in which the first absorbing layer completely covers the outer surface of the core part except for the portion
the process comprising the steps of:
- processing of the data by an electronic component included in the central part;
- transmission of the data processed by the antenna.

6. Method for receipt a signal by a connectivity box configured to be arranged under an outer part of an engine land vehicle and comprising at least one antenna and a centre part, the connectivity box comprising:
- a first absorbing layer comprising a phase-change material, the phase-change material being configured to absorb thermal energy emitted by the core;
- a second insulating layer configured to thermally insulate the first absorbing layer and the central part from an external thermal energy,
in which the first absorbing layer at least partially covers the outer surface of the central part and the second insulating layer totally covers the outer surface of the first absorbing layer,
in which the antenna is arranged on a portion of the outer surface of the core part, and in which the first absorbing layer completely covers the outer surface of the core part with the exception of the portion,
the process comprising the steps of:
- receipt of the signal by the antenna;
- signal processing by an electronic component included in the central part.
